# EUROPEAN PATENT APPLICATION

(11) **EP 4 102 717 A1**
(43) Date of publication of application: **14.12.2022**
(21) Application number: 21178181.0
(22) Date of filing: 08.06.2021
(51) Int. Cl.: H03F 3/183, H03F 3/217

(54) **SELF-OSCILLATING CLASS D AUDIO AMPLIFIER WITH VOLTAGE LIMITING CIRCUIT**

(71) Applicant: ICEpower a/s, 2860 Søborg (DK)
(72) Inventor: BOSTRÖM, Patrik, 256 57 Ramlösa (SE)
(74) Representative: Lind Edlund Kenamets Intellectual Property AB

(57) **Abstract**

A self-oscillating amplifier system comprising at least two integrator stages connected to receive an input signal and provide a reference signal, a comparator configured to provide a modulation signal based on the reference signal and a modulation feedback signal, and a switching stage connected to form a switching output signal. The system further comprises a voltage limiting circuit connected between the input of an initial integrator stage and the output of a final integrator stage, for limiting a voltage across the at least two integrator stages.

By connecting one single voltage limiting circuit across all integrator stages, the modulation signal will be limited to the voltage limit of this voltage limiting circuit.

## Description

### Field of the invention

This invention relates to voltage amplifiers in general and self-oscillating class D audio amplifiers in particular.

### Background of the invention

Switching Class D audio amplifiers have found increasing use in the industry in recent years, due to the improvements in output stage switching devices and equally in modulation and feedback control methods. The classical switching power amplifier system consists of a pulse modulator, for converting an analog or digital source into a pulse-modulated signal, which is amplified by a switching power stage. A passive demodulation filter reproduces the power modulated power signal.

Most switching class D amplifiers are based on variants of Pulse Width Modulation (PWM). Some of the challenges in switching amplifier design relates to the shortcomings of PWM, one in particular is problems associated with carrier generation since it limits system bandwidth and complicates design. Additionally, a stable and robust control system design is difficult to implement.

As a remedy to this, self-oscillating amplifiers were introduced, these are commonly classified into two categories: hysteresis-controlled oscillation and phase-shift controlled oscillation. An example of the latter in the form of a non-hysteresis controlled oscillation modulator (COM) is disclosed in WO 98/19391 and WO 2004/47286, both by the present applicant, ICEpower A/S, and both incorporated herein by reference. These methods are characterized by self-oscillation being determined by feedback after the demodulation filter, i.e. having the demodulation filter as an integral, determining part on self-oscillation conditions. Such architectures will in the following be referenced to as global controlled oscillation modulators (GCOM). The global controlled oscillation modulator based switching amplifier systems disclosed in prior art have a particular advantage in terms of wide closed loop gain bandwidth enclosing the output filter, such that filter distortion and output impedance is minimized. It is generally desirable to have as much open loop gain as possible in the operational range and as much open loop attenuation as possible outside of the operational range.

Generally speaking, an ideal voltage amplifier has the following characteristics:
- Constant gain at all frequencies in the operational (audio) range (20Hz to 20kHz).
- Constant gain with all load impedances (ignorable output impedance)
- Constant gain at all output voltages and all rates of change of output voltages (linear transfer function, no harmonic components or inter modulation components)
- Ignorable noise in the operational range
- Sufficient dV/dt capability to produce the desired output voltage at all frequencies in the operational range

With audio now being recorded with 192kHz sampling rates and even higher, it is desirable to have a much larger closed loop bandwidth (>100kHz). Also, in order to achieve low output impedance and a linear transfer function (Vₒᵤₜ/Vᵢₙ = k), a sufficiently large feedback factor (open loop gain/closed loop gain (G_{OL}/G_{CL}) or, expressed in dB, G_{OL}-G_{CL}) has to be achieved. In a class D amplifier this presents significant challenges.

To begin with, the output filter, which usually is of second order and includes an inductor and a capacitor, adds a delay and also causes a resonance with a Q-factor which varies with load. The resonant frequency is usually in the range of 40-60kHz (10-15µH inductance with 0.68 to 1.5µF capacitance). Using global feedback, this resonance can be suppressed so long as the needed dV/dt can be achieved, but if the amplitude or frequency of the desired output signal in combination with the load impedance exceeds what the output filter can track, then the loop will go into slew limiting. When this happens, there is a risk that integrators in the feedback loop will start to generate large excursions leading to delayed recovery which means that the amplifier can go into a slew limit induced oscillation (large signal instability). This problem can be significantly reduced by keeping the integrator excursion in a tightly controlled range, thereby preventing the integrator from generating the amplitude required to sustain switching at a too low frequency. An example of this solution is disclosed in EP 3 416 285.

Secondly, the switching frequency (f_{sw}) at which a self-oscillating class D amplifier performs switching varies as a parabola depending on D² where D is the modulation depth, i.e. the duty cycle, and just before hard clipping the switching frequency will typically be towel below 100kHz. When there is no load present or a highly inductive load is driven, the resulting high Q-factor in the output filter will cause the switching residual on the output to become very large when f_{sw} falls down close to the resonance frequency. If there is enough gain in the loop at high frequencies and time delay, then f_{sw} will drop further and this creates a conflict between the fact that large loop gain is desired in the operational range but attenuation is desired in the f_{sw}-range.

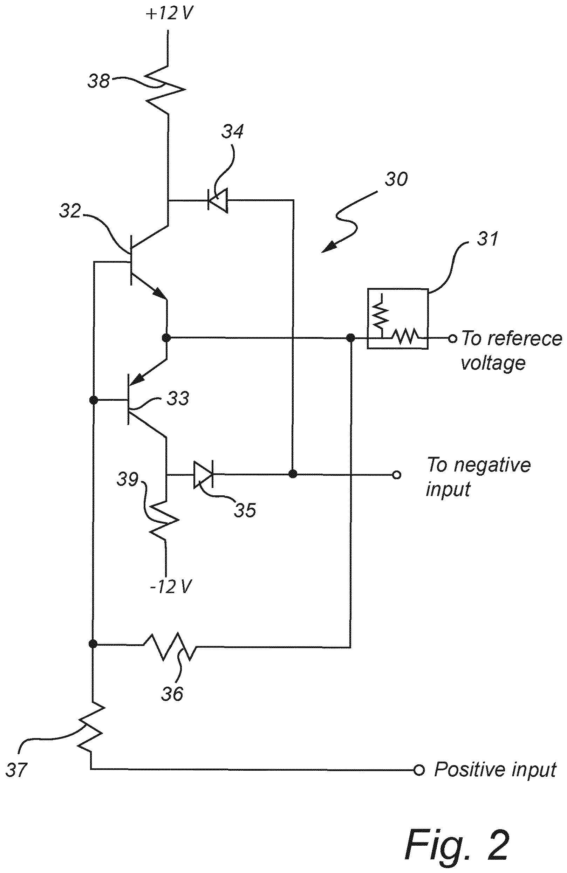

Figure 2 of Swedish patent SE 1 550 677 discloses a clamp circuit arranged to limit the signal at a negative input of an integrating input amplifier. The clamp circuit ensures stability in situations when there is a large difference between input and output, e.g. at start-up or during other saturation situations like current limiting or hard clipping. Figure 6 of SE 1 550 677 further discloses circuitry configured to provide an input signal and a compensation signal to the positive input of a non-inverting primary amplifier by sensing the signal on the negative input of the non-inverting primary amplifier and to remove any error by adding a compensation signal on the positive input of the non-inverting primary amplifier. Such circuitry may be referred to as a "modulation servo", which adds gain in the operational frequency range with very little effect on the closed loop frequency response curve.

### General disclosure of the invention

It is an object of the present invention to provide a class D amplifier system with improved performance during saturated conditions such as star-up.

According to a first aspect of the present invention, this and other objects are achieved by a self-oscillating amplifier system for amplifying an input signal in an operational frequency range, the system comprising at least two integrator stages connected to receive the input signal and provide a reference signal, a comparator configured to provide a modulation signal based on the reference signal and a modulation feedback signal, a switching stage connected to receive the modulated signal from the comparator and form a switching output signal, a demodulation filter connected to demodulate the switching output signal and form a demodulated output signal, and a feedback block connected to the output of the demodulation filter and configured to provide the modulation feedback signal. The feedback block has a transfer function configured to ensure self-oscillating conditions at a switching frequency, and provide a desired gain in the operational frequency range. The system further comprises a voltage limiting circuit connected between the input of an initial integrator stage and the output of a final integrator stage, for limiting a voltage across the at least two integrator stages.

The voltage limiting circuit may be similar to the clamp circuit discussed in SE 1 550 677. However, contrary to the circuitry disclosed in SE 1 550 677, the voltage limiting circuit according to the present invention is connected across at least two integrator stages.

If a separate limiter is used across each integrator stage, as suggested in SE 1 550 677, the overall voltage limit will be the sum of the voltage limit of each limiter. For example, a simple, inexpensive voltage limiting circuit may have a voltage limit of 0.6 V. With three cascaded integrator stages, and one such limiting circuit arranged across each integrator, a 3 x 0.6 V = 1.8 V modulation signal can be allowed on the class D stage input. This is typically too large to ensure stability. By instead connecting one single voltage limiting circuit across all integrator stages, the modulation signal will be limited to the voltage limit of the voltage limiting circuit, i.e. 0.6 V. It is noted that the specific votlage levels are only examples, but the principle remains the same.

A voltage divider may be connected between the reference signal and the voltage limiting circuit to adjust the reference signal (i.e. the voltage at the output of the final integrator stage) e.g. to be comparable to the input voltage at normal operating conditions.

Instead of using a voltage liming circuit as disclosed in SE 1 550 677, the voltage limiting circuit may include two bipolar transistors, e.g. an NPN and a PNP transistor, connected emitter-to-emitter.

The integrator stages may be of different type, such as first order or second order integrators. For example, the forward path may comprise two second order integrator stages. With this design, a fourth order (very steep) slope of the closed loop gain curve may be achieved, while still ensuring a sufficient phase margin to ensure stability.

The final integrator stage may also be a biquad acting as a modulation servo, as disclosed in the co-pending application Self-Oscillating Class D Audio Amplifier with Modulation Servo by the same applicant, herewith incorporated by reference.

### Brief description of the drawings

The present invention will be described in more detail with reference to the appended drawings, showing currently preferred embodiments of the invention.
Figure 1 is a schematic block diagram representation of a self-oscillating amplifier system in accordance with an embodiment of the present invention.
Figure 2 is a schematic circuit diagram of a limiting circuit according to an embodiment of the invention.
Figure 3 is a schematic block diagram representation of a self-oscillating amplifier system in accordance with a further embodiment of the present invention.
Figure 4 is a schematic circuit diagram of the modulation servo in figure 3.

### Detailed description of preferred embodiments

In the following detailed description, preferred embodiments of the present invention will be described. However, it is to be understood that features of the different embodiments are exchangeable between the embodiments and may be combined in different ways, unless anything else is specifically indicated. Even though in the following description, numerous specific details are set forth to provide a more thorough understanding of the present invention, it will be apparent to one skilled in the art that the present invention may be practiced without these specific details. In other instances, well known constructions or functions are not described in detail, so as not to obscure the present invention.

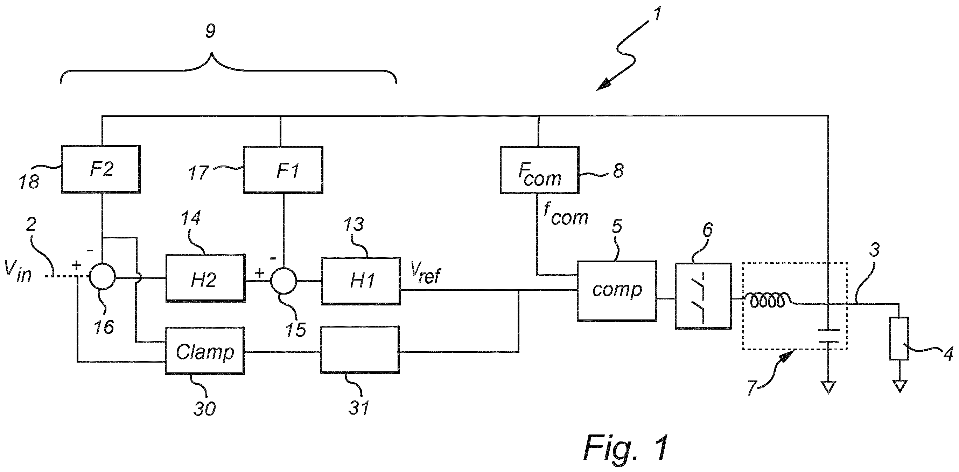

Fig. 1 illustrates a block diagram representation of a self-oscillating amplifier system 1 according to an embodiment of the invention. The amplifier system 1 has an input terminal 2 for receiving an input signal Vᵢₙ and an output terminal 3. A load 4 in the form of a speaker is connected to the output 3 of the amplifier system 1. A forward path 9 is connected to receive the input signal Vᵢₙ and provide a reference signal V_{ref}. A controlled oscillation modulator (COM) is connected to modulate and amplify this reference signal in an operational frequency range. A typical operational frequency range is 20 Hz to 20 kHz.

More specifically, the controlled oscillation modulator comprises a comparator 5 configured to provide a modulation signal based on the reference signal V_{ref} and a modulation feedback signal f_{com}, a switching stage 6 connected to receive the modulated signal and form a switching output signal, and a demodulation filter 7 arranged to demodulate the switching output from the switching stage 6. The switching power stage 6 can comprise one or a plurality of half-bridges, preferably a full-bridge comprising two half-bridges or a single half-bridge in single ended operation mode. In some implementations, the comparator and switching stage are integrated as one single component, referred to as a "power comparator". The demodulation filter 7 is here illustrated as a second order low pass LC-filter.

The system further comprises a feedback block 8 providing the modulation feedback signal f_{com} based on the output of the demodulation filter 7. This type of feedback is sometimes referred to as "global" feedback. The feedback is designed to ensure self-oscillating conditions at a switching frequency, and to provide a desired gain in the operational frequency range.

More specifically, the feedback block 8 transfer function F_{com}(s) comprises a lead placed at around twice the modulation filter resonance frequency, f_{cut-off}. The lead will act to compensate for at least a portion of the phase lag caused by the second order demodulation filter, so that the self-oscillation frequency can be moved up a decade from the filter resonance frequency. (In case a higher order demodulation filter is used, additional leads(s) may be required.) Finally, the feedback block 8 transfer function F_{com}(s) will also provide the desired gain in the operational frequency range. If the desired gain is A, the gain (attenuation) of the feedback block 8 should be 1/A.

The forward path 9 here includes one or several, in the illustrated example two, cascaded integrator blocks 13, 14 preceding the servo 20. The transfer function H₁, H₂ of each integrator block 13, 14 may be a second order integrator, but also other integrating transfer functions are possible.

Each integrator block 13, 14 has its input connected to the output of a preceding summation point 15, 16, which each provides a difference between an input signal and a respective feedback signal provided by feedback blocks 17 and 18 connected to the demodulation filter 7. In order to ensure that the signal amplified by the integrators, to the largest extent possible, does not include the input signal Vᵢₙ, the gain of each feedback block 17, 18 should be aligned with the gain of the modulator feedback block 8, i.e. 1/A as discussed above.

Each combination of feedback block, summation point and integrator block, 13, 15, 17 and 14, 16, 18 respectively, can be referred to as a global feedback integrator stage.

The output of the second integrator bock 13 is connected to the input of the servo 20 (i.e. the input of the summation point 11).

The output of the first, initial integrator block 14 is connected to the input of the summation point 15 preceding the second integrator block 13.

When the load is inductive or non-existing, the Q-factor of the demodulation filter 7 is large and the resonance high. This means that as the switching frequency drops at large modulation, the residual increases and will eventually start to significantly mix with the integrators. In a typical example implementation, the gain in the integrator stages crosses zero at around 70kHz so at for example 100kHz the attenuation is only around -3dB. If the integrators are allowed to generate a compensation signal (gain) of several volts, the amplifier is at risk of going into a locked state where it oscillates at a low frequency. Therefore it is beneficial to make sure that the compensation signal that the integrators can generate is limited to a level which is useful during normal, unclipped/unsaturated use.

For this purpose, the system in figure 1 comprises a voltage limiting circuit 30, connected between the reference voltage V_{ref} and the input 2 of the system. The voltage limiting circuit 30 is configured to limit the voltage across the integrator stages 13, 15, 17 and 14, 16, 18. A voltage divider 31 may be arranged preceding the clamping circuit, in order to ensure that the reference voltage V_{ref} is comparable to the input signal during normal use.

Figure 2 shows an example of a voltage limiting circuitry 30 and a voltage divider 31, where the voltage limiting circuit 30 circuit includes two bipolar transistors 32, 33 connected emitter-to-emitter. In the illustrated embodiment, the emitter of an NPN transistor 32 is connected to the emitter of a PNP transistor 33. The junction between the emitters is further connected to the reference voltage (via the resistive divider 31), while the collectors of the transistors are connected to the negative input of the summation point 16 via diodes 34, 35. The bases of the transistors are both connected to the (low impedance) input voltage, i.e. the positive input of the summation point 16. Pull-up resistors 38, 39, connected to positive and negative voltages, respectively (here +/-12 V), are provided to reduce any leakage current through the diodes flowing into the negative input of the summation point 16.

The circuit here includes two equal resistors 36, 37, serving as a voltage divider, thereby defining a voltage limit equal to two times the base-emitter voltage of the transistors. The circuit will serve to make the integrator stages into followers when the compensation signal exceeds this voltage. As an example, the base-emitter voltage may be 0.6 V, resulting in a voltage limit of 1.2 V in the illustrated circuit. Without the resistors 36, 37 the voltage limit would be 0.6 V.

A similar function may be achieved with Zener diodes. Of course, more complicated circuits can be used but with added complexity (references, OPAMPs, diodes) and larger footprint. A two stage inverting amplifier suitable for use as a voltage limiting circuit is disclosed in SE 1 550 677.

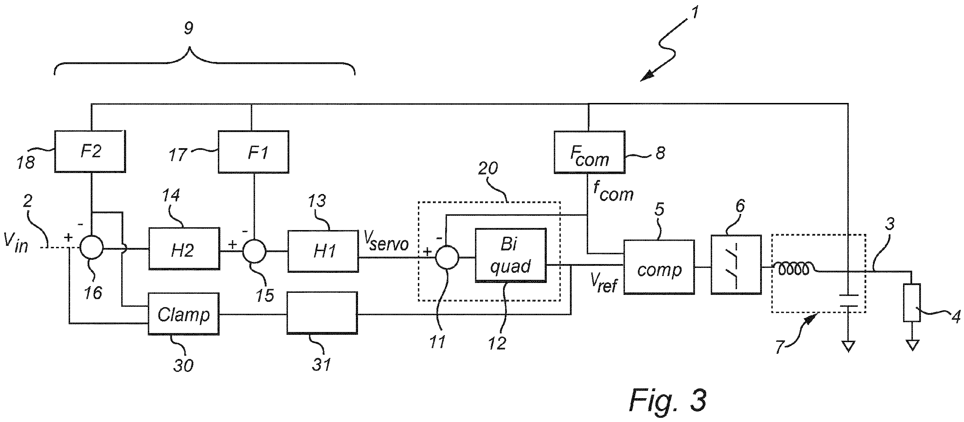

In a conventional global feedback controlled oscillation modulator (GCOM) the comparator 5 is typically connected to receive the reference signal V_{ref} on its positive input and the feedback signal f_{com} on its negative input, and to provide the modulation signal by comparing these two signals. Turning to the embodiment in figure 3, the system further comprises a circuit referred to as a modulation servo 20. The servo 20 comprises a summation point 11 and a biquad (bi-quadratic) filter 12.

The biquad filter 12 has a first gain in the operational frequency range, and a second, lower, gain outside this range. The gain changes rapidly from the first gain to the second gain over a narrow transitional frequency range. The summation point 11 has a first input connected to an input signal, a second input connected to the feedback signal f_{com}, and an output connected to provide a difference (error) between the input signal and the feedback signal to the biquad filter 12. The output of the biquad filter 12 is connected to the positive input of the comparator 5. The modulation servo will serve to amplify the error signal more in the operational frequency range, thereby improving performance.

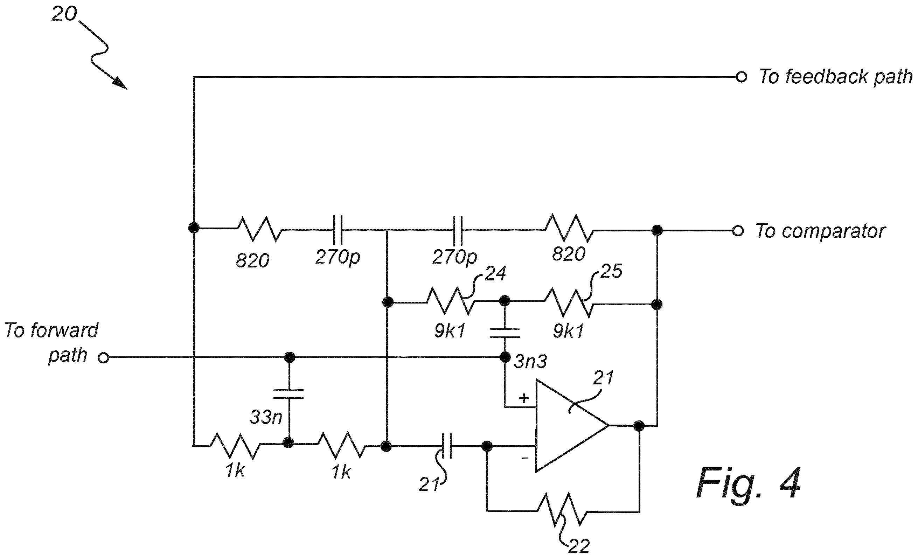

Figure 4 shows a circuit diagram of an example of the servo 20, connected to the feedback block 8 and summation point 9. In this case, the biquad filter is implemented as a "single-amplifier biquad", SAB, with one single operational amplifier 21. However, other topologies are also possible.

Further, a negative feedback resistor 22, and a capacitor 23 serve to ensure that the servo 20 does not affect the biasing DC offset of the comparator 5. The resistor 22 is an order of magnitude (ten times) greater than the sum of resistors 24, 25. As an alternative, a unity gain amplifier and a capacitor may be provided to prevent the servo 20 from affecting the biasing DC offset of the comparator.

The person skilled in the art realizes that the present invention by no means is limited to the preferred embodiments described above. On the contrary, many modifications and variations are possible within the scope of the appended claims. For example, the circuit topologies in figures 2 and 3 may be modified, as long as they implement a modulation servo 20 and clamping circuit 30 compatible with the invention. Also, any values for resistance, capacitance and inductance in the circuit diagrams are only provided as examples.

## Claims

1. A self-oscillating amplifier system (1) for amplifying an input signal (Vᵢₙ) in an operational frequency range, said system comprising:
at least two integrator stages (13, 15; 17; 14, 16, 18; 11, 12) connected to receive the input signal (Vᵢₙ) and provide a reference signal (V_{ref}),
a comparator (5) configured to provide a modulation signal based on the reference signal (V_{ref}) and a modulation feedback signal (f_{com}),
a switching stage (6) connected to receive the modulated signal from the comparator and form a switching output signal,
a demodulation filter (7) connected to demodulate the switching output signal and form a demodulated output signal, and
a feedback block (8) connected to the output of the demodulation filter and configured to provide said modulation feedback signal (f_{com}),
wherein the feedback block (8) has a transfer function configured to:
ensure self-oscillating conditions at a switching frequency, and
provide a desired gain in the operational frequency range, **characterized by**
a voltage limiting circuit (20) connected between the input of an initial integrator stage and the output of a final integrator stage, for limiting a voltage across said at least two integrator stages.

2. The self-oscillating amplifier system (1) according to claim 2, further comprising a voltage divider (21) connected between the reference signal (V_{ref}) and said voltage limiting circuit (30).

3. The self-oscillating amplifier system (1) according to claim 1 or 2, wherein said voltage limiting circuit (20) includes two bipolar transistors (32, 33), connected emitter-to-emitter.

4. The self-oscillating amplifier system (1) according to claim 3,
wherein said voltage limiting circuit (30) includes an NPN transistor (32) and a PNP transistor (33) connected emitter-to-emitter,
wherein a junction between the emitters is connected to the output of the reference signal (V_{ref}),,
wherein the collectors of the transistors are connected to the negative input of the summation point (16) via two diodes (34, 35), and
wherein bases of the transistors are connected to the input signal, Vᵢₙ.

5. The self-oscillating amplifier system (1) according to claim 1,
wherein the initial integrator stage (14, 16, 18) has a positive input connected to said input signal (Vᵢₙ), and a negative input connected to a feedback path (18) from said demodulation filter output, and
wherein each following integrator stage (13, 15, 17; 11, 12) has a positive input connected to an output of a preceding integrator stage, and a negative input connected to a feedback path from said demodulation filter output.

6. The self-oscillating amplifier system (1) according to claim 1 or 2, wherein said at least two integrator stages include at least two second order integrator stages (13, 15; 14, 16).

7. The self-oscillating amplifier system (1) according to claim 6, wherein the feedback path (17, 18) of each integrator stage has a gain corresponding to an inverse of said desired gain (A).

8. The self-oscillating amplifier system (1) according to one of claims 1 - 5, wherein the final integrator stage includes:
a summation point (11) connected to provide a difference signal as a difference between said modulation feedback signal (f_{com}) and a servo input signal (Vₛₑᵣᵥₒ) from a preceding integrator stage (13, 15, 17), and
a biquad filter (12) connected to receive the difference signal and to provide a filter output, said biquad filter (12) having a first gain in said operational frequency range and a second, lower, gain outside said operational frequency range.

9. The self-oscillating amplifier system (1) according to claim 8, wherein the biquad filter (12) is implemented as a single-amplifier biquad.
